# EUROPEAN PATENT APPLICATION

(11) **EP 4 432 359 A1**
(43) Date of publication of application: **18.09.2024**
(21) Application number: 23161807.5
(22) Date of filing: 14.03.2023
(51) Int. Cl.: H01L 27/06, H01L 29/417, H01L 29/78

(54) **SEMICONDUCTOR DIE WITH A VERTICAL DEVICE**

(71) Applicant: Infineon Technologies Austria AG, 9500 Villach (AT)
(72) Inventor: NOEBAUER, Gerhard, 9500 Villach (AT); FERRARA, Alessandro, 9523 Villach (AT); YUFEREV, Sergey, 9500 Villach (AT); GASSER, Florian, 9020 Klagenfurt am Wörthersee (AT)
(74) Representative: König Szynka Tilmann von Renesse Patentanwälte Partnerschaft mbB München

(57) **Abstract**

The disclosure relates to a semiconductor die (1) with a semiconductor body (2), the semiconductor die (1) comprising a vertical transistor device (10) formed in a first area (11) of the semiconductor body (2), the vertical transistor device (10) comprising a source region (15) at a first side (2.1) of the semiconductor body (2), and a drain region (16) at a second side (2.2) of the semiconductor body (2); a first electrical isolation (40) between the first area (11) and a second area (12) of the semiconductor body (2); and a diode (50) in the second area (12) of the semiconductor body (2); wherein a cathode contact (62) of the diode (50) is electrically connected to the source region (15) of the vertical transistor device (10).

## Description

### TECHNICAL FIELD

The present application relates to a semiconductor die comprising a vertical transistor device.

### BACKGROUND

A source region of the vertical transistor device is disposed on a first side of a semiconductor body and its drain region is disposed vertically opposite on a second side of the semiconductor body. A gate electrode for controlling a current flow between the source and the drain region can particularly be arranged in a gate trench which extends from the first side into the semiconductor body.

### SUMMARY

It is an object of the present application to provide an advantageous semiconductor die with a vertical transistor device, as well as a method of manufacturing the same.

In addition to the transistor device, the semiconductor die of claim 1 comprises a first electrical isolation between a first area in which the vertical device is disposed and a second area of the semiconductor body. In the second area, a diode is disposed, wherein a cathode contact of the diode is connected to the source region of the vertical device. In comparison to a so-called body diode, this diode is connected the other way around, its cathode contact connected to the source domain of the device. The diode can for instance provide an alternative current path, e. g. from a supply voltage to ground during a switching event. The transistor can for instance be used or connected as a high-side switch, e.g. in a step-down converter, and the integrated diode can reduce the loop inductance, e. g. the equivalent length of the current loop.

In general words, an approach of this application is to combine a transistor and a diode in the same die, wherein the cathode contact of the diode is connected to the source of the transistor. For the integration, the transistor and the diode can be arranged in different areas of the die, wherein these areas can particularly be electrically isolated from each other. Particular embodiments and features are provided throughout this disclosure and in the dependent claims. Therein, the individual features shall be disclosed independently of a specific claim category, the disclosure relates to apparatus and device aspects, but also to method and use aspects. If for instance a die manufactured in a specific way is described, this is also a disclosure of a respective manufacturing process, and vice versa.

In the intended use, the first electrical isolation between the first and the second area of the semiconductor body can for instance isolate a ground potential from an input potential. In general words, it can allow for applying at least two different electrical potentials to the first side and/or the second side of the semiconductor body. Generally, the electrical isolation can for instance be a junction isolation or a deep trench isolation. For the deep trench isolation, an insulating filler can be arranged in the deep trench, which electrically isolates the first and the second area of the semiconductor body from each other. Seen in a vertical top view, the deep trench can in particular form a closed line, e. g. surround the second area completely. In other words, the second area can be embedded laterally into the first area of the semiconductor body.

The semiconductor body can comprise a semiconductor substrate and for instance one or several epitaxial layers on the substrate. In an epitaxial layer or layers, for instance the source region and/or a body region and/or a drift region of the vertical device can be arranged. The deep trench can in particular extend down into the semiconductor substrate, e. g. intersect it completely when viewed in a vertical cross-section. In general words, the deep trench can reach vertically from the first side of the semiconductor body to the vertically opposite second side thereof. In addition to the insulating material filler, another filler can be arranged in the trench, see the exemplary embodiments for illustration.

Source and drain of the vertical transistor are arranged at vertically opposite sides of the semiconductor body. A gate region of the device can capacitively couple to a body region made of an opposite doping type to form a channel in the body region. In particular, the gate region can be arranged in a trench extending from the first side into the semiconductor body, a vertical channel formed laterally aside the trench.

"Vertical" or "vertically" refers to the vertical direction which lies for instance perpendicular to a surface of the die, e. g. a surface of the semiconductor body. The first and second side of the semiconductor body lie vertically opposite. "Above" means vertically aligned and closer to the first side of the semiconductor body or frontside of the die, "below" means vertically aligned and closer to the second side of the semiconductor body or the backside of the die. An "upper" portion is closer to the first side than a "lower portion". "Lateral" or "laterally" refers to the lateral directions perpendicular to the vertical direction, in which for instance the different areas of the semiconductor body are arranged aside each other.

In general, the diode can be formed laterally between a respective p- and n-region, e. g. at the first side of the semiconductor body, with a lateral current path through the diode. In particular, however, the diode is formed between two portions of the semiconductor body which are arranged vertically one above the other. In other words, a current path can in particular extend vertically through the diode. With the vertical diode, the thickness of the semiconductor body can for instance be used for increasing the blocking voltage, the vertical diode having in particular the same blocking voltage like the vertical device in the first area of the die.

In an embodiment, a first doping region which forms an anode contact of the diode is arranged at the first side of the semiconductor body. The diode is formed between the first doping region and a lower portion of the semiconductor body below the first doping region. The lower portion of the semiconductor body in the second area can in particular lie on the same vertical height like a drift region of the vertical device in the first area. The lower portion can particularly have the same doping type and profile like the drift region of the vertical device. In general words, the first doping region and the lower portion of the semiconductor body have an opposite doping type, the first doping region being in particular p-doped and the lower portion n-doped, e. g. n-doped with a lower concentration compared to an n-doped drain region of the vertical device.

A second doping region arranged in the second area on the first side of the semiconductor can form the cathode contact of the diode, e. g. be electrically connected to the source region of the vertical device. The second doping region is of the same doping type like the lower portion of semiconductor body, but it can for instance have a higher doping concentration compared thereto. The second doping region can in particular be n-doped, whereas the first doping region is p-doped. Viewed as a whole, a current path through the diode can extend down and upwards in the semiconductor body, e. g. have basically a U-shape between the first and the second doping region.

In an embodiment, the electrical connection between the second doping region and the source region of the vertical device is formed by a first metal pad. The first metal pad is arranged on the first side of the semiconductor body and extends laterally across the first electrical isolation, bridging for instance the deep trench isolation. In case that more than one metallization layer is arranged on the first side of the semiconductor body, the first metal pad can be formed in the lowermost metallization layer, in an intermediate and/or in particular in an uppermost metallization layer. The metal pad can for instance be formed in a copper layer, in particular in a top copper layer.

In an embodiment, a low-doped region is arranged laterally between the first and the second doping region in this area of the semiconductor body. It can for instance have the same doping type but a lower doping concentration compared to the second doping region, e.g. be low n-doped. The low-doped region can for instance be of the same doping type and profile like the drift region of the vertical device.

In an embodiment, a high-doped region is disposed below the first and/or second doping region in the second area, it can in particular be an n-doped region. The high-doped region is for instance disposed on the second side of the semiconductor body. Compared to the low-doped region discussed above, it can be of the same doping type but have a higher doping concentration. Vertically between the first doping region and the high-doped region, the lower portion of the semiconductor body can be arranged. The second doping region can for instance extend deeper into the semiconductor body than the first doping region, in particular it can extend down to the high-doped region, e. g., be in a direct electrical contact therewith.

As mentioned above, a current path through the diode can have a U-shape between the first and the second doping region, namely have a downward and an upward portion (one through diode and the other one between the high-doped region and the second doping region), as well as a lateral portion in the high-doped region in between the downward and the upward portion. Independently of these details, the high-doped region can in particular be of the same doping type and profile like the drain region of the vertical device, e. g. be manufactured in the same process step (reuse of existing process steps).

In an embodiment, a fourth metal pad is disposed on the second side in the second area of the semiconductor body. The fourth metal pad can for instance be formed in the same backside metallization layer like a drain metallization. In general, this can be an alternative to the high-doped region, e. g. form a lateral portion of a U-shaped current path. In particular, the fourth metal pad can be combined with the high-doped region, namely be in electrical contact with the high-doped region. The fourth metal pad can for instance be floating, e. g. be not connected in the package.

In an embodiment, a second electrical isolation is disposed between the second area and a third area of the semiconductor body. Seen in a vertical cross-section, the second area or a portion of the second area can be enclosed laterally between the first and the second electrical isolation, the first area arranged on one lateral side thereof and the third area arranged on the other lateral side thereof. Seen in a vertical top view, the areas can be nested one in the other, the second area embedded into the first area, separated by the first electrical isolation which forms a closed line, and the third area embedded into the second area, separated by the second electrical isolation which forms a closed line. Like the first electrical isolation, the second electrical isolation can in particular be a deep trench isolation, the first and the second isolation can particularly be made in the same process steps.

In an embodiment, the anode contact, in particular the first doping region of the diode, which is arranged at the first side of the semiconductor body, is electrically connected to the second side in the third area of the semiconductor body. In other words, the contact is routed from the first side to the second side there. Likewise, the anode contact of the diode can be connected on the second side of the semiconductor body, e. g. from the backside of the die. There, a connection can be formed in the package, e. g. a ground connection. In still other words, the ground connection can be routed from the frontside to the backside in the third area of the semiconductor body.

In an embodiment, a second metal pad extends across the second electrical isolation at the first side of the semiconductor body. The second metal pad can in particular be formed in a lowermost metallization layer and/or in the same metallization layer like the first metal pad discussed above. The second metal pad extending across the second electrical isolation can connect the first doping region / anode contact in the second area and a third doping region at the first side in the third area of the semiconductor body. The third doping region can be of the same doping type like the second doping region, e. g. be n-doped. The second and third doping region can particularly be made simultaneously, e. g. in the same implantation step. They can for instance have the same depth and doping profile. The third doping region can contact a high-doped region at the second side in the third area of the semiconductor body, which can in particular be of the same doping type and profile like the drain region of the vertical device and/or like the high doped region at the second side in the second area of the semiconductor body.

In an embodiment, a frontside metal layer covers a lower metallization layer in which the first and/or second metal pad is/are formed. The frontside metal layer can be thicker and/or made of another material than the lower metallization layer, e. g. be a frontside copper layer on a lower aluminum layer. Independently of these details, the second metal pad can for instance be electrically isolated from the frontside metal layer by an insulating layer vertically in between, in particular by an imide layer. In the first area of the semiconductor body, the insulating layer can be interrupted to form an electrical contact between the lower metallization layer and the frontside metal layer (source metallization), the frontside metal layer can in particular be in a direct contact to the lower metallization layer.

In an embodiment, a third metal pad is formed on the second side to contact the anode contact of the diode in the third area. In the package, the third metal pad can be connected to a ground contact, see the remarks above. According to one embodiment, the third metal pad can extend solely within the third area, e. g. within the boundary of the second electrical isolation. In an alternative embodiment, however, the third metal pad extends across the second electrical isolation into the second area. This can for instance increase an area available for contacting the third metal pad. The third metal pad extending into the second area can in particular be an alternative to the fourth metal pad discussed above. In the second area, the third metal pad can be electrically isolated from the semiconductor body by an insulating layer disposed on the second side of the semiconductor body, for instance silicon oxide.

The insulating layer can in particular be made of the same insulating material like an insulating filler of the deep trench isolation. The insulating filler can be deposited after the trench has been etched and cover at least the sidewalls of the deep trench. Process wise, the insulating layer on the second side can in general be a residuum of the trench fill process, which is for instance removed in the first area to allow for an electrical contact to the drain region, but can remain in the second area and serve as an electrical isolation between the semiconductor body and the third metal pad there. Alternatively, the insulating layer can be deposited in a separate process step, e. g. subsequent to the trench fill steps.

In an embodiment which can relate to a reuse of existing process steps as well, the first doping region is of the same doping type and profile like the body region of the vertical device. The first doping region and the body region can in particular be made in the same implantation step. Alternatively or in addition, the first doping region can be arranged between trenches which are of the same type like gate trenches of the vertical device. In other words, the area where the first doping region is formed or is to be formed, and the active area with the vertical device can be processed simultaneously, e. g. as regards a trench etch and also trench fill, but for instance apart from a source doping applied to the active area and omitted in the area of the second doping region.

The application relates also to a semiconductor package comprising a semiconductor die disclosed here. In particular, an anode contact of the diode can be electrically connected to a ground contact of the package, e. g. by a respective ground clip or wire. The remaining backside apart from the third metal pad and/or fourth metal pad can particularly be on a common drain potential. The package can for instance be a chip embedded package and/or the die can be mounted with the second side up (flip chip).

The application relates also to a step-down converter (buck converter), namely a DC-to-DC converter stepping down the voltage from an input to an output. The transistor with which the diode is integrated in the same die can in particular be connected as a high side switch of the converter, the diode connected between the source contact of the high side switch and a ground domain of the converter. For that purpose, the die with the high side switch can have an additional pin, namely ground contact. This contact can be connected to a ground pin of a package. In addition, the converter comprises a low side switch connected between the source contact of the high side switch and the ground domain. In particular, the die with the low side switch can be arranged in the same package with the die comprising the high side switch, particularly both dies being connected to the same ground pin. In the converter, inductances between the voltage supply and the switches can occur, which can for instance result in switching losses or might even lead to an avalanche risk.

The diode monolithically integrated with the high side switch can reduce the inductance by providing an alternative current path between the supply voltage and the ground domain (reducing an equivalent length of the current loop). During switching, the low side switch only has diode properties (its gate is on source potential) so that the monolithically integrated diode on the high side has the same properties but a lower inductance due to the integration. The die with the vertical device and the diode act as a monolithically integrated half bridge during switching, whereas the transistor devices are separated in conduction mode (assuming separate dies for the high side and low side switch, which can be less complex than a fully integrated solution).

The application relates also to a method of manufacturing a die disclosed here. Regarding further processing details, in particular with respect to simultaneous process steps, reference is made to the description above.

### BRIEF DESCRIPTION OF THE DRAWINGS

Below, the semiconductor die with the vertical transistor device and the diode are explained in further detail by means of exemplary embodiments. Therein, the individual features can also be relevant in a different combination.
- Figure 1: shows a portion of a semiconductor die with an integrated diode;
- figure 2: shows another portion of the die and illustrates vertical transistor devices;
- figure 3: shows a diode comparable to that of figure 1, with a different backside metallization;
- figure 4: shows a portion of a die and illustrates some additional details;
- figure 5: shows a detailed view of vertical devices of the embodiment of figure 4;
- figure 6: shows a detailed view of the diode of the embodiment of figure 4;
- figure 7: shows a cross-section illustrating some manufacturing details;
- figure 8: shows a circuit diagram of a step-down converter;
- figure 9: summarizes some manufacturing steps;
- figure 10: illustrates some packaging details.

### DETAILED DESCRIPTION

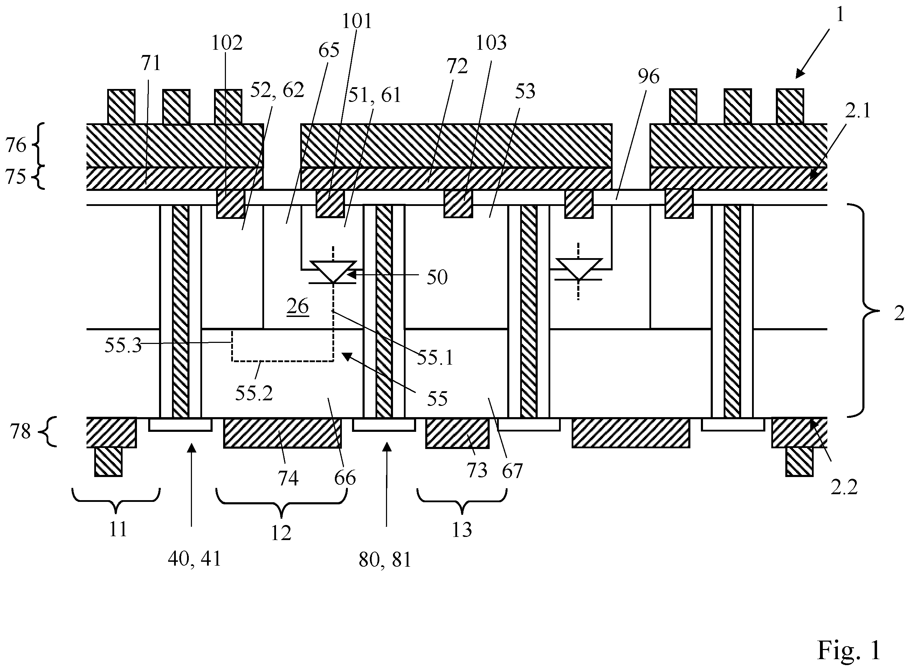

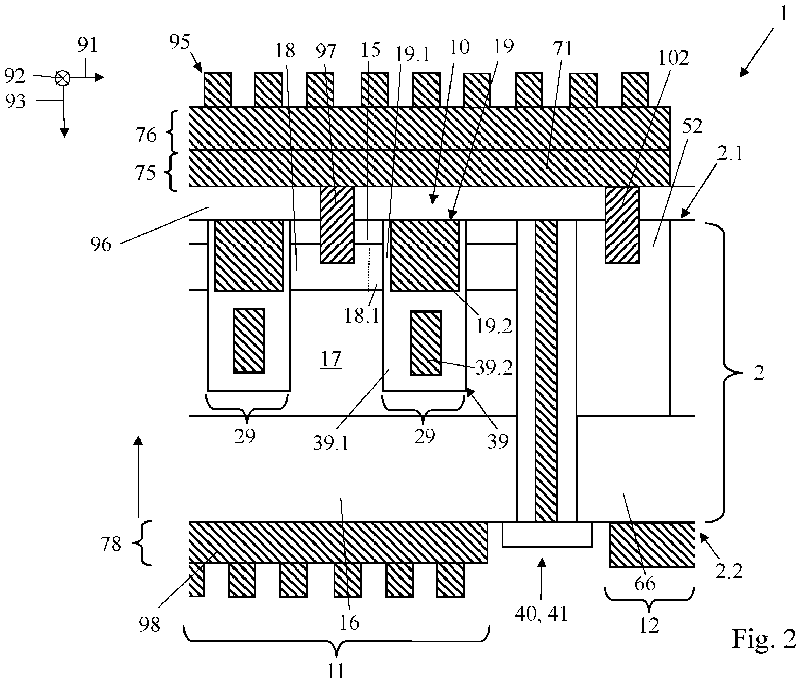

Figure 1 shows a portion of a semiconductor die 1 in which a vertical transistor device, see figure 2 in details, and a diode 50 are combined. The vertical device is disposed in a first area 11 and the diode 50 is disposed in a second area 12 of a semiconductor body 2. The first and the second area 11, 12 are electrically isolated from each other by a first electrical isolation 40 which is a deep trench isolation 41 in the example shown. The diode 50 is formed between a first doping region 51, p-doped in this example, which is disposed at a first side 2.1 of the semiconductor body 2 and a lower portion 26. The lower portion 26 is a low-doped n-region.

A current path 55 through the diode 50 is shown schematically as a dashed line. It has a downward and an upward portion 55.1, 55.3 as well as a lateral portion 55.2 in between. The lateral portion 55.2 is disposed in a high-doped region 67, e. g. formed in the semiconductor substrate extending over the whole die, at the second side 2.2 in the third area 13. At the first side 2.1 of the semiconductor body 2 a second doping region 52 is disposed, which is an n-doped sinker implant that can reach deeper than the first doping region 51. The first and the second doping region 51, 52 are spaced via a low-doped region 65. The second doping region 52 is the cathode contact 62 of the diode 50. Via a first metal pad 71 formed in a (lower) metallization layer 75, the second doping region 52 and cathode contact 62 of the diode 50, thus, are connected to the source domain of the vertical device, see in detail below.

Via a second metal pad 72 electrically isolated from the first metal pad 71, an anode contact 61 of the diode 50, namely first doping region 51, is electrically connected to a ground domain, e. g. in or via a third area 13 of the semiconductor body 2 to a third metal pad 73 on the second side 2.2. Between the second and the third area 12, 13, a second electrical isolation 80 is disposed, which is a deep trench isolation 81 as well. For connecting the second metal pad 72 on the first side 2.1 to the third metal pad 73, a third doping region 53, which can be a sinker implant like the second doping region 52 and be formed in the same implant step, is disposed in the third area 13 at the first side 2.1 of the semiconductor body 2. At the second side 2.2, another high-doped region 67 is arranged.

The third metal pad 73 can be formed in the same metallization layer 78 like a fourth metal pad 74 in the second area 12 and like a drain metallization of the vertical device, see below. In the example shown, the fourth metal pad 74 is floating, whereas the third metal pad 73 will be connected to a ground contact.

Figure 2 shows another portion of the die 1, namely the first area 11 with the vertical transistor device 10. It comprises a source region 15 at the first side 2.1 and a drain region 16 at the second side 2.2 of the semiconductor body 2. The source and drain region 15, 16 are both n-doped, vertically in between a p-doped body region 18 is arranged. Laterally aside the body region 18, a gate region 19 is disposed in a gate trench 29 which extends from the first side 2.1 into the semiconductor body 2. The gate region 19 comprises a gate dielectric 19.1 and gate electrode 19.2 which capacitively couples to the body region 18 to form a channel region 18.1. Below the gate region 19 a field electrode region 39 is disposed in the trench 29, comprising a field dielectric 39.1 and a field electrode 39.2 which capacitively couples to the drift region 17. The drain region 16 is of the same doping type and profile like the high-doped regions 66 and 67 in the second and third area 12, 13.

The sectional plane of figure 2 lies parallel to a first lateral direction 91 and to a vertical direction 93. In the first lateral direction 91, a plurality of respective device cells with trenches 29 are arranged aside each other in the first area 11. In a second lateral direction 92, the trenches 29 respectively have an elongated extension, forming a stripe pattern seen in a vertical top view. In general, however, the trenches can also have another lateral extension, e. g. be gate trenches in a grid pattern seen in a top view, for instance in combination with a respective needle-shaped field electrode centrally in the cells of the grid.

In the metallization layer 78, a drain metallization 98 is formed on the second side 2.2. On the first side 2.1, a source metallization 95 is formed in the lower metallization layer 75 and in the frontside metallization layer 76. In detail, an insulating layer 96 is disposed on the first side 2.1 and the electrical connection to the source metallization 95 is formed by a body and source contact 97 extending through the insulating layer 96. The insulating layer 96 extends also in the second area 12, where the electrical contact to the first metal pad 71 and source metallization 95, thus, is made by a second contact 102. The second metal pad 72 is connected to the first doping region 51 via a first contact 101 and to the third doping region 53 via a third contact 103. On the source metallization 95, and also on the drain metallization 98, vias for a contact formation in the package are disposed.

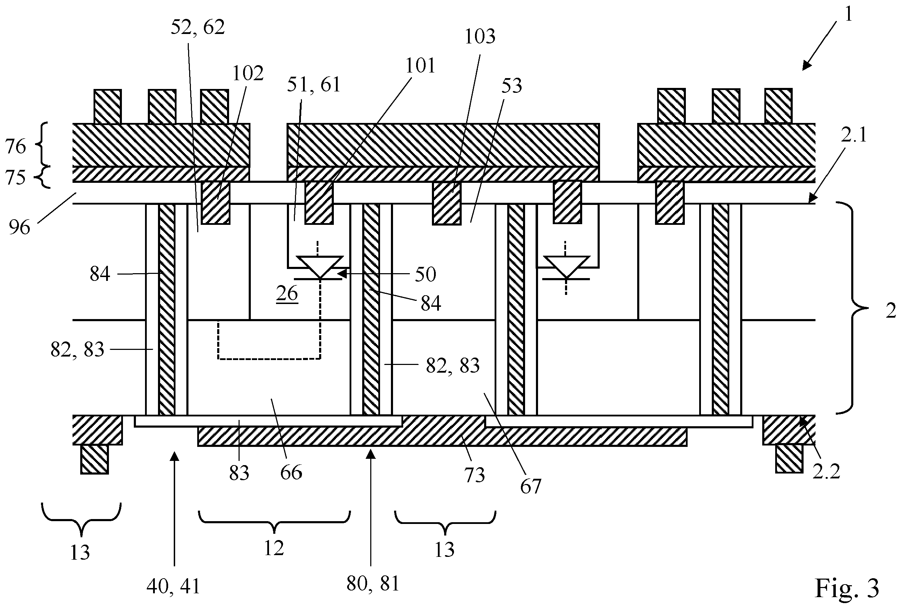

Figure 3 shows a view comparable to figure 1 and illustrates in particular the diode 50 and its wiring. Generally, in this disclosure, the like reference numerals indicate the like parts or parts with the like function and reference is respectively made to the description of the other figures as well. The following description mainly highlights the differences between the embodiments of figures 1 and 3, which concerns the metallization concept on the second side 2.2. The third metal pad 73 in figure 3 extends from the third area 13 across the second electrical isolation 80 into the second area 12. Vice versa, the floating metallization provided there in figure 1 (fourth metal pad 74) is omitted. The third metal pad 73 is electrically isolated from the second side 2.2 in the second area 12 of the semiconductor body 2 by an insulating material 83. The same insulating material 83 forms an insulating filler 82 of the deep trench isolation 81, which applies analogously for the deep trench isolation 41. In the example shown, the deep trench isolations 41, 42 additionally comprise a conductive filler 84 made of polysilicon and embedded into the insulating filler 83.

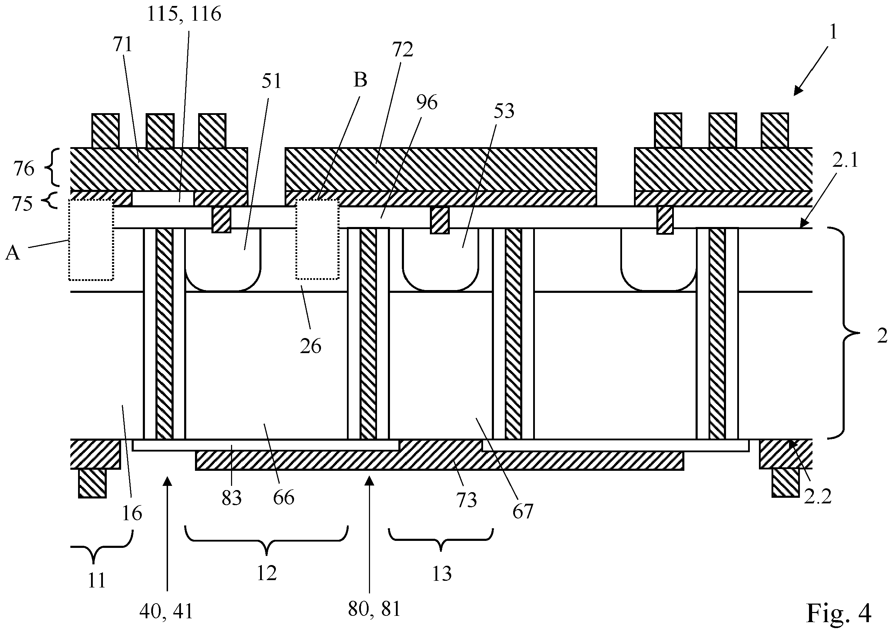

Figure 4 shows an embodiment basically comparable to figure 3 as regards the metallization structure on the second side 2.2. The first metal pad 71 is solely formed in the frontside metallization layer 76, the lower metallization layer 75 is interrupted there by an insulating layer 115, in particular imide layer 116. Laterally, a respective copper bridge does not necessarily extend along the whole length of the deep trench, one or a plurality of copper bridges can be formed locally. Where the frontside metallization layer 76 is in contact with the lower metallization layer 75, the imide has been removed prior to the copper deposition.

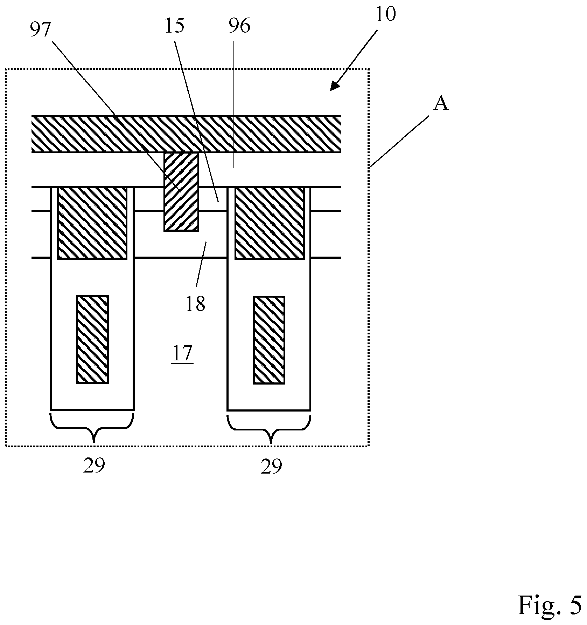

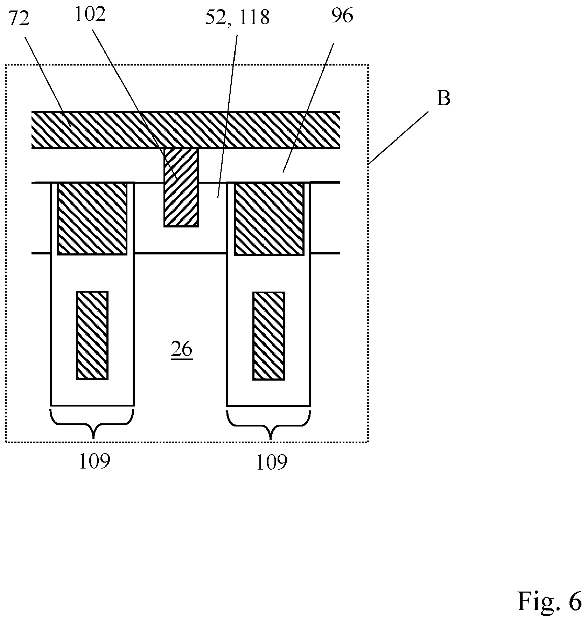

In connection with figures 5 and 6 showing detailed views of figure 4, in particular a specific setup of the first doping region 61 is illustrated. The first and the third doping region 51, 53 are respective sinker implants and the high-doped regions 66, 67 correspond to the drain region 16 in their doping type and profile.

Further details of the second doping region become apparent from a comparison of the detailed views A, B. The detailed view A in figure 5 illustrates a part of the vertical transistor device 10, namely the source region 15, the body region 18 and the drift region 17, as well as the gate trenches 29, see figure 2 for further details. The detailed view B shown in figure 6 is captured on the same vertical position but in the second area 12 instead. The second doping region 52 is made of a body implant 118 from which the body region 18 is formed in the same process step. In comparison to the active cell, the source doping is omitted. Alternatively, the source implant could be kept and the gate could be shorted to the source. The second contact 102 can be formed in the same process step like the body and source contact 97 of the transistor device 10. Like in the active cell, trenches 109 can be formed in the area of the diode, e. g. simultaneously with the gate trenches 29. The trenches 109 can for instance be filled like the gate trenches 29.

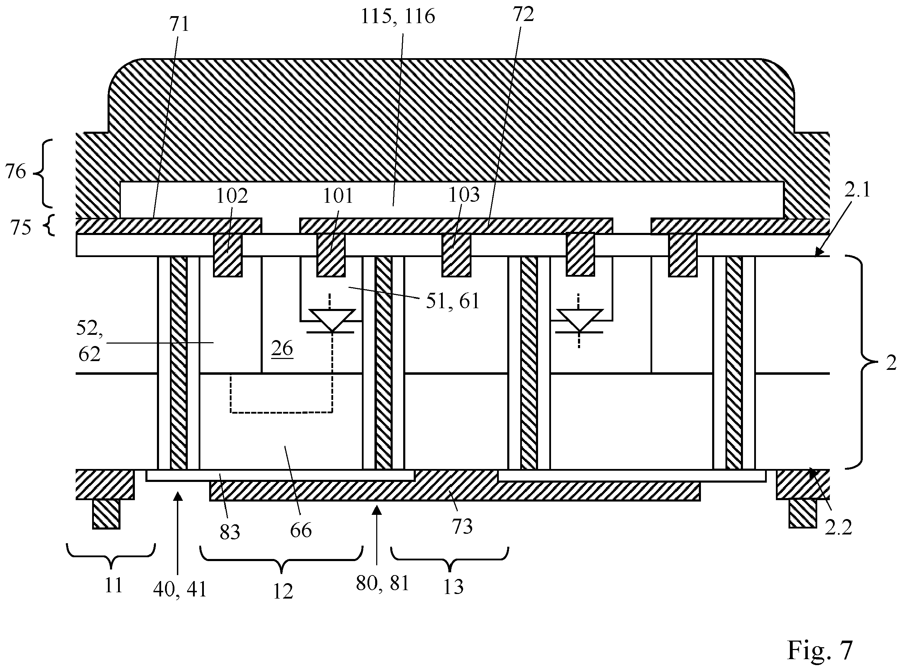

Figure 7 illustrates yet another embodiment, wherein the metallization structure on the second side 2.2 is comparable to the embodiments of figures 3 and 4. However, the metallization on first side 2.1 differs. In the lower metallization layer 75, the first and second metal pad 71, 72 are formed. The frontside metallization layer 76 contacts the lower metallization layer 75 in the first area 11, like in the embodiments discussed so far, but extends further into the second and third area 12, 13. There, the frontside metallization layer 76 is electrically isolated from the second metal pad 72 by an insulating layer 115 which is an imide layer 116 in the example shown.

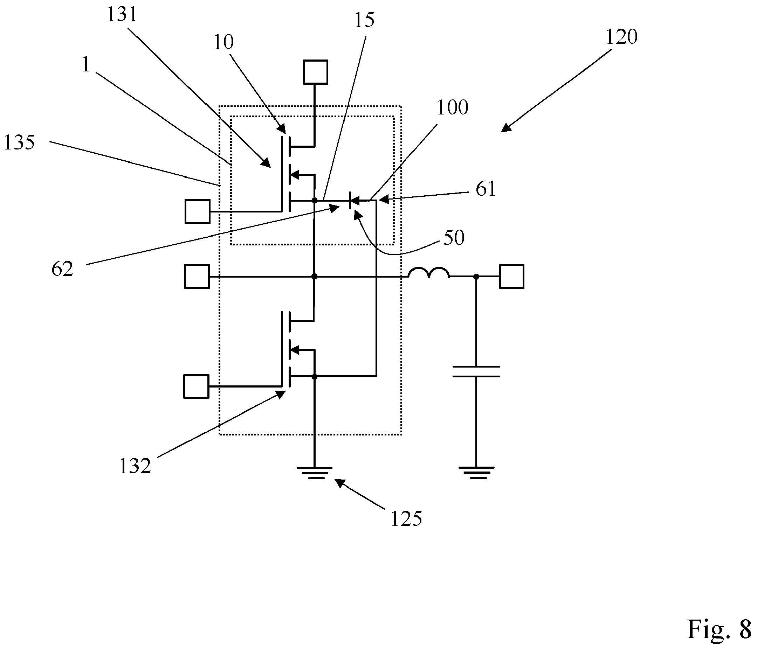

Figure 8 shows a circuit diagram of a step-down converter 120. It is a DC-to-DC converter to step down an input voltage Vᵢₙ to a lower output voltage Vₒᵤₜ. The step-down converter 120 comprises a die 1 in a package 135, the die 1 comprising a vertical transistor device 10 and a monolithically integrated diode 50 as discussed above. The cathode contact 62 of the diode 50 is connected to the source of the vertical transistor device 10 (monolithically in the die 1, see above), and the anode contact 61 is connected to the ground domain 125. The vertical transistor device 10 is connected as a high side switch 131 between the load and the output, another transistor being connected as a low side switch 132 between the output and the ground domain 125. During a switching event, the diode 50 can provide an alternative current path between Vᵢₙ and ground, which can reduce parasitic inductances.

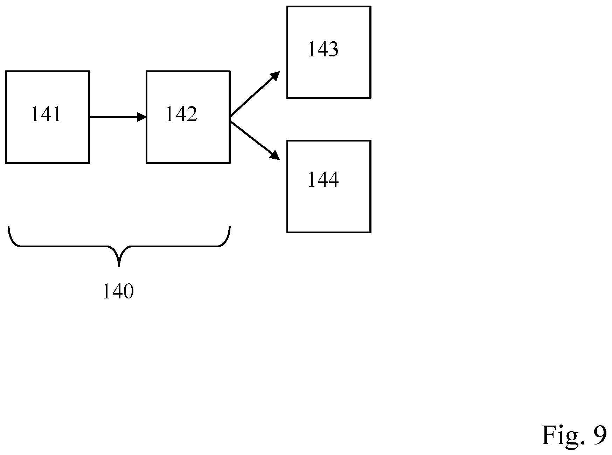

Figure 9 summarizes some manufacturing steps in a flow diagram. A forming 140 of the first electrical isolation can for instance comprise a trench etch 141 and subsequent trench fill 142. A forming 143 of the vertical transistor device and a forming 144 of the diode can at least to some extent be done simultaneously, see for instance the remarks on figures 5 and 6.

## Claims

1. A semiconductor die (1) with a semiconductor body (2), the semiconductor die (1) comprising:
a vertical transistor device (10) formed in a first area (11) of the semiconductor body (2), the vertical transistor device (10) comprising:
a source region (15) at a first side (2.1) of the semiconductor body (2), and
a drain region (16) at a second side (2.2) of the semiconductor body (2);
a first electrical isolation (40) between the first area (11) and a second area (12) of the semiconductor body (2); and
a diode (50) in the second area (12) of the semiconductor body (2);
wherein a cathode contact (62) of the diode (50) is electrically connected to the source region (15) of the vertical transistor device (10).

2. The semiconductor die (1) of claim 1, further comprising:
a first doping region (51) arranged in the second area (12) at the first side (2.1) of the semiconductor body (2), forming an anode contact (61) of the diode (50); and
a second doping region (52) arranged in the second area (12) at the first side (2.1) of the semiconductor body (2), forming the cathode contact (62) of the diode (50);
wherein the diode (50) is formed between the first doping region (51) and a lower portion (26) of the semiconductor body (2) below the first doping region (51), and
wherein the lower portion (26) is electrically connected to the source region (15) via the second doping region (52).

3. The semiconductor die (1) of claim 2, wherein the electrical connection between the second doping region (52) and the source region (15) is formed by a first metal pad (71) extending across the first electrical isolation (40) formed in the semiconductor body (2).

4. The semiconductor die (1) of claim 2 or 3, wherein a low-doped region (65) made of an opposite doping type than the first doping region (51) is laterally disposed between the first doping region (51) and the second doping region (52), the low-doped region (65) being in particular of the same doping type and profile like a drift region (17) of the vertical transistor device (10).

5. The semiconductor die (1) of any one of claims 2 to 4, further comprising:
a high-doped region (66) disposed below the second doping region (52) in the second area (12) at the second side (2.2) of the semiconductor body (2), the high-doped region (66) being in particular of the same doping type and profile like the drain region (16) of the vertical transistor device (10).

6. The semiconductor die (1) of any one of the preceding claims further comprising:
a fourth metallization pad (74) in the second area (12) on the second side (2.2) of the semiconductor body (2), which is in an electrical contact with the second side (2.2) of the semiconductor body (2).

7. The semiconductor die (1) of any one of the preceding claims, further comprising:
a second electrical isolation (80) formed between the second area (12) and a third area (13) of the semiconductor body (2), wherein an anode contact (61) of the diode (50) is electrically connected to the second side (2.2) of the semiconductor body (2) in the third area (13), in particular via a second metal pad (72) extending across the second electrical isolation (80).

8. The semiconductor die (1) of claim 7 in combination with claim 3, wherein the first metal pad (71) and a second metal pad (72) which extends across the second electrical isolation (80) are formed in the same metallization layer (75) and covered by a frontside metallization layer (76).

9. The semiconductor die (1) of claim 7 or 8, wherein a third metal pad (73) is formed in the third area (13) on the second side (2.2) of the semiconductor body (2) to contact the anode contact (61) of the diode (50).

10. The semiconductor die (1) of claim 9, wherein the third metal pad (73) on the second side (2.2) of the semiconductor body (2) extends across the second electrical isolation (80) into the second area (12) of the semiconductor body (2).

11. The semiconductor die (1) of claim 10 in combination with claim 5, wherein the third metal pad (73) is electrically isolated from the semiconductor body by an insulating material (83) arranged on the second side (2.2) of the semiconductor body (2), the insulating material (83) being in particular identical to an insulating material (83) of which an insulating filler (82) of a deep trench isolation (81) forming the second electrical isolation (80) between the second and the third area (12, 13) is made.

12. The semiconductor die (1) of any one of the preceding claims, further comprising:
a first doping region (51) arranged in the second area (12) at the first side (2.1) of the semiconductor body (2), forming an anode contact (61) of the diode (50);
wherein the first doping region (51) is of the same doping type and profile like a body region (18) of the vertical transistor device (10); and/or
wherein the first doping region (51) is arranged between trenches (109) which are of the same type like gate trenches (29) of the vertical transistor device (10).

13. A semiconductor package (135) comprising:
the semiconductor die (1) of any one of the preceding claims;
wherein an anode contact (61) of the diode (50) is electrically connected to a ground contact of the semiconductor package (135).

14. A step-down converter (120) comprising the semiconductor die (1) of any one of claims 1 to 12, the vertical transistor device (10) connected as a high-side switch (131) and an anode contact (61) of the diode (50) connected to a ground domain (125).

15. A method of manufacturing the semiconductor die (1) of any one of the preceding claims, comprising:
i) forming the vertical transistor device (10) in the first area (11) of the semiconductor body (2);
ii) forming the first electrical isolation (40) between the first area (11) and a second area (12) of the semiconductor body (2), and
iii) forming the diode (50) in the second area (12) of the semiconductor body (2).

## Amended claims

### Amended claims in accordance with Rule 137(2) EPC.

1. A semiconductor die (1) with a semiconductor body (2), the semiconductor die (1) comprising:
a vertical transistor device (10) formed in a first area (11) of the semiconductor body (2), the vertical transistor device (10) comprising:
a source region (15) at a first side (2.1) of the semiconductor body (2), and
a drain region (16) at a second side (2.2) of the semiconductor body (2);
a first electrical isolation (40) between the first area (11) and a second area (12) of the semiconductor body (2); and
a diode (50) in the second area (12) of the semiconductor body (2);
wherein a cathode contact (62) of the diode (50) is electrically connected to the source region (15) of the vertical transistor device (10),
the cathode contact (62) being connected to the source region (15) via a first metal pad (71),
**characterized in that** the anode contact (61) is connected to a second metal pad (72) electrically isolated from the first metal pad (71).

2. The semiconductor die (1) of claim 1, further comprising:
a first doping region (51) arranged in the second area (12) at the first side (2.1) of the semiconductor body (2), forming an anode contact (61) of the diode (50); and
a second doping region (52) arranged in the second area (12) at the first side (2.1) of the semiconductor body (2), forming the cathode contact (62) of the diode (50);
wherein the diode (50) is formed between the first doping region (51) and a lower portion (26) of the semiconductor body (2) below the first doping region (51), and
wherein the lower portion (26) is electrically connected to the source region (15) via the second doping region (52).

3. The semiconductor die (1) of claim 2, wherein the electrical connection between the second doping region (52) and the source region (15) is formed by the first metal pad (71) extending across the first electrical isolation (40) formed in the semiconductor body (2).

4. The semiconductor die (1) of claim 2 or 3, wherein a low-doped region (65) made of an opposite doping type than the first doping region (51) is laterally disposed between the first doping region (51) and the second doping region (52), the low-doped region (65) being in particular of the same doping type and profile like a drift region (17) of the vertical transistor device (10).

5. The semiconductor die (1) of any one of claims 2 to 4, further comprising:
a high-doped region (66) disposed below the second doping region (52) in the second area (12) at the second side (2.2) of the semiconductor body (2), the high-doped region (66) being in particular of the same doping type and profile like the drain region (16) of the vertical transistor device (10).

6. The semiconductor die (1) of any one of the preceding claims further comprising:
a fourth metallization pad (74) in the second area (12) on the second side (2.2) of the semiconductor body (2), which is in an electrical contact with the second side (2.2) of the semiconductor body (2).

7. The semiconductor die (1) of any one of the preceding claims, further comprising:
a first doping region (51) arranged in the second area (12) at the first side (2.1) of the semiconductor body (2), forming an anode contact (61) of the diode (50);
wherein the first doping region (51) is of the same doping type and profile like a body region (18) of the vertical transistor device (10); and/or
wherein the first doping region (51) is arranged between trenches (109) which are of the same type like gate trenches (29) of the vertical transistor device (10).

8. A method of manufacturing the semiconductor die (1) of any one of the preceding claims, comprising:
i) forming the vertical transistor device (10) in the first area (11) of the semiconductor body (2);
ii) forming the first electrical isolation (40) between the first area (11) and a second area (12) of the semiconductor body (2), and
iii) forming the diode (50) in the second area (12) of the semiconductor body (2).
